Europäisches Patentamt

European Patent Office

Office européen des brevets

(19)

(11) **EP 1 273 523 A1**

(12) **EUROPEAN PATENT APPLICATION**
published in accordance with Art. 158(3) EPC

(43) Date of publication:
**08.01.2003 Bulletin 2003/02**

(51) Int Cl.⁷: **B65D 1/00**, B65D 85/00,
B65D 85/72, B32B 1/02,
B32B 9/00, C23C 16/27

(21) Application number: **00935496.0**

(22) Date of filing: **31.05.2000**

(86) International application number:
**PCT/JP00/03487**

(87) International publication number:
**WO 01/062605 (30.08.2001 Gazette 2001/35)**

(84) Designated Contracting States:
**AT BE CH CY DE DK ES FI FR GB GR IE IT LI LU
MC NL PT SE**
Designated Extension States:
**AL LT LV MK RO SI**

(30) Priority: **24.02.2000 JP 2000048387**

(71) Applicant: **MITSUBISHI SHOJI PLASTICS
CORPORATION
Shinagawa-ku, Tokyo 141-8535 (JP)**

(72) Inventors:
• **HAMA, Kenichi
Shinagawa-ku, Tokyo 141-8535 (JP)**
• **KAGE, Tsuyoshi
Shinagawa-ku, Tokyo 141-8535 (JP)**

(74) Representative:
**Bunke, Holger, Dr.rer.nat. Dipl.-Chem.
Prinz & Partner GbR
Manzingerweg 7
81241 München (DE)**

(54) **PLASTIC CONTAINER FOR LIQUID CONTAINING VOLATILE ORGANIC SUBSTANCE**

(57)    A plastic container for a liquid material containing a volatile organic substance having a DLC (diamond-like carbon) film formed on the inner surface thereof, characterized in that the DLC film has a specific composition, density and thickness, and the container exhibits flavor-barrier property for a fragrant or smelling organic substance and gas-barrier property for a volatile organic compound. Such barrier properties of the container are achieved by employing a DLC film having respectively appropriate composition, density and thickness. The container is suitable for filling a volatile organic substance such as an agricultural chemical, a cosmetic, a seasoning or an aromatic material.

Fig.1

EP 1 273 523 A1

**Description**

**TECHNICAL FIELD**

The present invention is related to a DLC film coated plastic container having adaptability as a container filled with liquid containing volatile organic substances. In particular, the present invention is related to a DLC film coated plastic container having adaptability as a container filled with agricultural chemicals, cosmetics beginning with perfume, seasonings beginning with vinegar, aromatic materials and the like.

In this regard, the term liquid does not only mean liquids, and also includes fluids and semifluids. The term fluids refers to liquids having a high viscosity such as starch syrup, and the term semifluids refers to not only matter in which the same substance is present in solid phase and liquid phase states such as tomato ketchup, but also a wide variety of mixtures in which different substances are present in solid phase and liquid phase states such as mayonnaise. Further, the term liquid also includes solutions in which a solute is dissolved in a solvent, and liquids impregnated in a carrier.

**PRIOR ART TECHNOLOGY**

Generally, because containers made of plastic are easy to form, and have light weight and low cost, such containers are widely used as filled containers in various fields such as foods and medicines and the like.

However, because aromatic components are sorbed by and permeate through plastic containers, there have been the problems that odors leak to the outside of the container, and odors remain in open containers after use.

Further, because the organic solvent vapor barrier properties are insufficient, there has also been the problem that organic solvents evaporate to the outside of the container, whereby the concentration of the filled liquid increases.

Furthermore, plastic containers have permeability properties for oxygen and water vapor. For example, even in plastic containers which have properties that make it difficult for nonpolar gas molecules such as oxygen and the like to permeate through, polar molecules such as water molecules and the like are able to permeate through because the permeation mechanism inside the plastic is different from that of the nonpolar molecules. On the other hand, even in plastic containers which have properties that make it difficult for polar molecules such as water molecules and the like to permeate through, nonpolar gas molecules such as oxygen and the like are able to permeate through. Consequently, there are virtually no plastic containers having properties which make it difficult for both nonpolar molecules such as oxygen and carbon dioxide and polar molecules such as water and the like to permeate through.

Currently, polyvinylidene chloride containers are the only plastic containers understood by the inventors to have moderate aroma barrier properties, volatile organic solvent vapor barrier properties, oxygen gas barrier properties and moistureproof properties.

However, polyvinylidene chloride containers have the disadvantage of having poor mechanical properties. Further, in the case where an incineration process is carried out for waste, a high temperature incineration is required due to the inclusion of chlorine.

For this reason, when compared to glass containers and the like, plastic containers have various restrictions relating to the object of use and the type of use.

Incidentally, in the case where liquids containing volatile organic substances, in particular agricultural chemicals, cosmetics beginning with perfume, seasonings beginning with vinegar, aromatic materials and the like are filled and packaged, there should preferably be no leaking of the aromatic components to the outside of the container, no change in the concentration of the filled liquid due to gas permeation of the organic solvent, and no occurrence of quality deterioration due to contamination with oxygen and water vapor. However, because plastic containers have properties such as ease of forming, light weight and low cost and the like, it would be extremely convenient to be able to use plastic containers as containers filled with liquid as described above.

The technology described below has been disclosed in response to this kind of demand. Japanese Laid-Open Patent Publication No. HEI 8-53116 discloses a plastic container which has a DLC (Diamond Like Carbon) film formed on the inner wall surfaces of the container. This container is provided with the properties of (1) good transparency so that the foreign material inspection is not hindered, and (2) little oxygen permeability.

Further, Japanese Laid-Open Patent Publication No. HEI 8-53117 discloses a manufacturing apparatus and a manufacturing method for this type of container. Further, Japanese Laid-Open Patent Publication No. HEI 10-258825 discloses a manufacturing apparatus for mass producing a DLC film coated plastic container, and a manufacturing method thereof. Furthermore, Japanese Laid-Open Patent Publication No. HEI 10-226884 discloses a manufacturing apparatus which makes it possible to apply a coating of DLC film without mottling to a container having protrusions which protrude from the outer surface to the outside, and a manufacturing method thereof.

This DLC film is a film called an i-carbon film or an amorphous carbon hydride film (a - C : H), and also includes a hard carbon film. Further, a DLC film is an amorphous-state carbon film, and includes $SP^3$ bonding. By forming this kind of DLC film on the inner wall surfaces of a plastic container, a container is obtained which can be used as a container for carbonated beverages and sparkling beverages and the like.

Japanese Laid-Open Patent Publication No. HEI 11-70152 discloses a film and the like for medical containers, wherein a diamond state carbon film having a hydrogen concentration of 50 atomic % or less and an oxygen concentration of $2 \sim 20$ atomic % is formed on at least one surface of a plastic film. Such film is a film that has transparency, oxygen barrier properties and water vapor barrier properties. This publication discloses embodiments related to polypropylene and polyethylene films which have superior water vapor barrier properties as material properties, but through which it is easy for oxygen to permeate. The oxygen permeability of $25\mu m$ biaxial oriented polypropylene is 17.3 ml/$m^2$/day. Further, the water vapor permeability is 4.5 g/$m^2$/day which is an improvement of barrier properties by a factor of about 2 or 3 times.

However, even this DLC film coated plastic container does not satisfy the requirements that in addition to the basic properties that there should be (1) good transparency so that the foreign material inspection is not hindered, and (2) no chemical reaction between the container and liquid contents, otherwise the compounding agents, there should also be (3) aromatic component barrier properties, (4) organic solvent vapor barrier properties, (5) little water vapor permeability, and (6) little oxygen permeability, and the like.


## SUMMARY OF THE INVENTION

It is an object of the present invention to provide a DLC film coated plastic container having adaptability as a container filled with liquid for which it is desired that the leaking of aromatic components to the outside of the container be made extremely small, liquid for which it is desired that changes in concentration of the solvent due to gas permeation of an organic solvent be prevented, and liquid for which it is desired that quality deterioration due to contamination with oxygen and water vapor be prevented.

The present invention is a plastic container having a DLC (Diamond Like Carbon) film formed on the inner surfaces thereof, wherein said plastic container has flavor barrier properties for aromatic organic substances, and gas barrier properties for volatile organic solvents by specifying the composition, density and film thickness of the DLC film. In this way, because aromatic components and volatile organic solvents do not leak to the outside of the container, it is possible to provide a container in which the concentration of the contents is kept at a fixed level, and in which it is difficult for quality deterioration of the contents to occur.

Further, the present invention includes the case where the volatile organic solvent described above is ethanol, methanol, ethyl acetate, normal hexane, xylene or toluene. In this way, because the container of the present invention has flavor barrier properties and gas barrier properties for general volatile organic solvents, the container of the present invention is usable as a container filled with various substances.

Furthermore, among volatile organic solvents, in particular the present invention includes a DLC film coated plastic container having an ethanol vapor permeability of $0 \sim 0.06$g/container/month. In this way, because the aromatic components do not leak to the outside, and because the vapor of ethanol which is one of the main components does not escape to the outside, it is possible to provide a container which can maintain the concentration of the contents at a fixed level.

Furthermore, the present invention includes a DLC film coated plastic container having a water vapor permeability of $0 \sim 0.006$g/container/day, and an oxygen permeability of $0 \sim 0.011$ml/container/day. In this way, in addition to the properties of the container described above, it is possible to provide a container having functions such as in the case where (1) the solvent includes water in addition to the main component, the water is prevented from evaporating to the outside of the container, or contamination with water vapor from the outside of the container is prevented, and this makes it possible to maintain the concentration of the contents at a fixed level, and in the case where (2) the contents easily undergo quality deterioration due to oxygen or water, it is possible to prevent this, and the like.

Further, the gas permeabilities of the nonpolar molecules nitrogen, oxygen and carbon dioxide for plastic are said to obey the general relationship 1 : 3.8 : 24.2 (Packaging Designs of Medicine, Masayasu Sugihara, Nanzando page 275). The DLC film coated plastic container of the present invention which has oxygen gas barrier properties also has carbon dioxide gas barrier properties in accordance with this general relationship.

The DLC film is formed from carbon atoms and hydrogen atoms, for example, polyethylene resin is also formed from the same atoms. However, in contrast with polyethylene which has both oxygen and water vapor permeabilities like other plastic resins, the DLC film coated container of the present invention has extremely low permeabilities for both of these gases. For these reasons, the present inventors presume the following.

A DLC film having a large hydrogen content of 50 atomic % will have a density lowered to $1.2 \sim 1.3$, and the carbon atoms and hydrogen atoms will form a polymer state. At this time, because the DLC film has expansion properties, cracks will not form by the expansion of the container, but because this is not a dense film, it is presumed that it will be easy for oxygen and water to permeate through.

Generally, in a plasma CVD (Chemical Vapor Deposition) method, when the high-frequency applied electric power is raised, the negative self-bias becomes large, and when the negative self-bias becomes large, a dense film is possible and the density of the film becomes higher due to the acceleration of the impact of positive ions. Further, there is a tendency for the negative self-bias to become larger as the pressure is lowered at the time of film formation.

When the high-frequency applied electric power is lowered, because a sufficient bias will not be provided, the synthesized DLC film will include a large number of hydrogen and graphite-like $SP^2$ bonds, a spongy film will be formed, and the density of the film will also be small.

When the film thickness is too thin, the film will be patchy in a state where there are open holes, and the entire surface will not be covered. Further, when the film thickness becomes too thick, compressive stress occurs in the film itself, and this causes the film to crack and peel off.

Accordingly, the DLC film according to the present invention does not have gas barrier properties against oxygen and water vapor because it is a DLC film. In particular, these properties are obtained by appropriately changing the three conditions of composition, density and film thickness.

In this regard, the composition of the DLC film of the present invention is determined by the hydrogen atomic % and the carbon atomic %. Namely, theoretically due to the manufacturing conditions, it is possible for oxygen to be included as a structural atom other than hydrogen and carbon, but the amount thereof is extremely small. The oxygen atomic % is less than 0.2 atomic % (X-ray photoelectric spectral method, Model SSX-100 (manufactured by SSI Company) ). Accordingly, in the DLC film of the present invention, if the hydrogen atomic % is 20 atomic %, the carbon atomic % is approximately 80 atomic %.

Further, because the density of the DLC film of the present invention means the apparent density, if the film composition is determined, the density is not necessarily determined. Namely, even for the same composition, if the deposition rate is changed, because the apparent density and denseness will change, this will have an effect on the gas barrier properties.

In the present invention, in particular by appropriately changing these three conditions, the DLC film coated container of the present invention is obtained. In the present invention, the composition, density and film thickness of the DLC film are indicated for carrying out appropriate changes.

As described later in the example embodiments, from the viewpoint of the ethanol vapor barrier properties, the three conditions of the DLC film are as follows. Namely, the composition condition is that the hydrogen atomic % is 10 $\sim$ 35 atomic %, and preferably 12 $\sim$ 30 atomic %. The density condition is 1.6 $\sim$ 2.2g/cm$^3$, and preferably 1.7 $\sim$ 2.1 g/cm$^3$. The film thickness condition is 220 $\sim$ 400Å, and preferably 250 $\sim$ 370Å.

Further, in addition to the case of ethanol, because the container of the present invention will have the same organic solvent vapor barrier properties even when the volatile organic solvent is methanol, ethyl acetate, normal hexane, xylene or toluene, it is possible to use the container of the present invention as a plastic container for liquid containing volatile organic substances.

From the viewpoint of the oxygen barrier properties, the three conditions of the DLC film are as follows. Namely, the composition condition is that the hydrogen atomic % is 8 $\sim$ 45 atomic %, and preferably 10 $\sim$ 40 atomic %. The density condition is 1.3 $\sim$ 2.2g/cm$^3$, and preferably 1.4 $\sim$ 2.0 g/cm$^3$. The film thickness condition is 150 $\sim$ 450Å, and preferably 180 $\sim$ 420Å.

From the viewpoint of the water vapor barrier properties, the three conditions of the DLC film are as follows. Namely, the composition condition is that the hydrogen atomic % is 10 $\sim$ 40 atomic %, and preferably 15 $\sim$ 35 atomic %. The density condition is 1.6 $\sim$ 2.1g/cm$^3$, and preferably 1.7 $\sim$ 2.0 g/cm$^3$. The film thickness condition is 180 $\sim$ 350Å, and preferably 200 $\sim$ 320Å.

Accordingly, in order to obtain a plastic container for liquid containing volatile organic substances equipped with ethanol vapor barrier properties, oxygen barrier properties and water vapor barrier properties, this is achieved by establishing the three conditions of the DLC film as follows. Namely, the composition condition is that the hydrogen atomic % is 10 $\sim$ 35 atomic %, and preferably 15 $\sim$ 30 atomic %. The density condition is 1.6 $\sim$ 2.1g/cm$^3$, and preferably 1.7 $\sim$ 2.0 g/cm$^3$. The film thickness condition is 220 $\sim$ 350Å, and preferably 250 $\sim$ 320Å.

In the case where the three conditions described above are satisfied, it is possible to provide a plastic container for liquid containing volatile organic substances which has an ethanol vapor permeability of 0 $\sim$ 0.06g/container/month, and in addition to ethanol vapor barrier properties, it is possible to provide a plastic container for liquid containing volatile organic substances which has a water vapor permeability of 0 $\sim$ 0.006g/container/day, and an oxygen permeability of 0 $\sim$ 0.011ml/container/day.

The present invention is a plastic container in which a DLC film is formed on the inner surfaces thereof, and the liquid containing volatile organic substances described above is an agricultural chemical, a cosmetic, a seasoning, or an aromatic material.

As for liquid agricultural chemicals, there are emulsions, liquid agents, water-dispersible agents and suspended emulsifiers, and the container of the present invention can be used in the case of being filled with these.

With regard to emulsions, there are formulations in which effective components that are difficult to dissolve in water are dissolved in a solvent to which an emulsifier is added, with the main agent having a content of 20 $\sim$ 75%.

With regard to solvents, selection and use thereof is carried out by considering solubility, safety, economics and the like, and xylene and the like are used. These are superior from the point of control effect, price and the like, and are types of agents used frequently for fruit tree cultivation and vegetable cultivation.

Liquid agents are agents in which highly water-soluble components that are difficult to dissolve in solvents are dissolved in water, with a spreading agent and the like added thereto.

Water-dispersible agents refer to solid formulations in which effective components that are difficult to dissolve in water are adsorbed on or mixed with a powdered carrier, and even though these agents are similar to powder agents, these agents are used in a state where they are suspended and dispersed in water.

Suspended emulsions refer to liquid agent which do not have the disadvantages of inflammability of emulsions, toxicity, and drift of water-dispersible agents, and are formulations in which a solid source body is pulverized and dispersed in a liquid to form a slurry state. There are many formulations dispersed in water, and these are generally called flowable agents.

These agricultural chemicals have been used by being filled into glass containers, but there have been problems such as a risk of breakage at the time of transport, the trouble of processing agricultural chemicals remaining on the inner surfaces of the containers after use, and the like. The container of the present invention is of course able to suppress quality deterioration of agricultural chemicals due to gas permeation and solvent permeation, and in addition to this, because the container of the present invention is difficult to break and can undergo an incineration disposal after the agricultural chemicals are used, there is the result that it is possible to solve the processing problems after use.

Agricultural chemicals such as organic phosphate agents, carbamate insecticides and dithiocarbamate germicides decompose under the presence of water or oxygen. With regard to these agricultural chemicals, the container of the present invention has the advantage of being able to suppress quality deterioration because it has oxygen and water vapor barrier properties, and can undergo incineration disposal after use.

The agricultural chemicals include pyrethrin from pyrethrum, nicotine, DDT, BHC, drine insecticide, diazinon, malathion, NAC, MTMC, MIPC, blastocidin, kasugamycin, zineb, maneb, IBP, EDDP, methyl bromide, chloropicrin, TPN, captan, benomyl, 2,4-PA, MCP, IPC, burban, DCMU, Linuron, bensulfuron-methyl, DCPA, ala chlor, simazine, simetryn, CNP, chlomethoxyfen, paraquat, trifluralin, and glyphosate.

Because the container of the present invention has organic solvent, for example, ethanol barrier properties, it is possible to use the container of the present invention for toilet water and the like which contain ethanol and the like.

Because the container of the present invention has acetic acid vapor barrier properties, it is possible to use the container of the present invention for liquid seasonings, for example, edible vinegar which has a strong odor.

Because the container of the present invention has aromatic component barrier properties, it is possible to use the container of the present invention for liquid aromatic materials.

The present invention is a plastic container in which a DLC film is formed on the inner surfaces thereof, and this plastic container includes containers formed from polyethylene terephthalate resin. As for the plastic, polyethylene terephthalate resin, polyethylene resin, polypropylene resin, polystyrene resin, cycloolefin copolymer resin, polyethylene naphthalate resin, ethylene-vinyl alcohol copolymer resin, poly-4-methylpentene-1 resin, polymethyl methacrylate resin, acrylonitrile resin, polyvinyl chloride resin, polyvinylidene chloride resin, acrylonitrile-styrene resin, acrylonitrile-butadiene-styrene resin, polyamide resin, polyamide-imide resin, polyacetal resin, polycarbonate resin, polybutylene terephthalate resin, ionomer resin, polysulfone resin, or ethylene tetrafluoride resin may be used, but polyethylene terephthalate is more preferred, and when a DLC film is formed on a container made of polyethylene terephthalate, the container will exhibit superior properties.

## BRIEF DESCRIPTION OF THE DRAWINGS

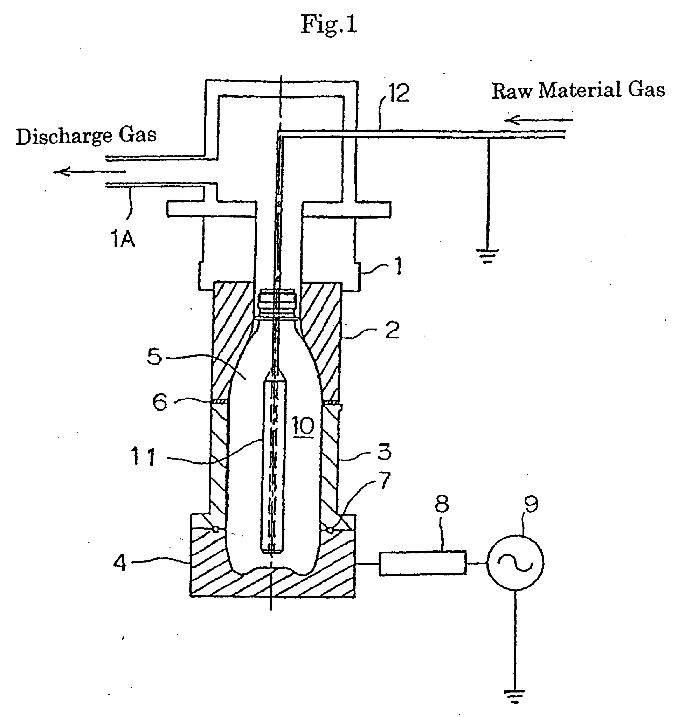

Fig. 1 is a drawing showing one example of a manufacturing apparatus for manufacturing the plastic container for liquid containing volatile organic substances according to the present invention. In the drawing, 1 is a base, 1A is an exhaust outlet, 2 is a shoulder portion electrode, 3 is a body portion electrode, 4 is a bottom portion electrode, 5 is a plastic container, 6 is an insulator, 7 is an O-ring, 8 is an interface device, 9 is a high-frequency oscillator, 10 is a housing portion, 11 is an inner electrode, and 12 is a pipeline.

## PREFERRED EMBODIMENTS OF THE INVENTION

First, a description will be given for the manufactured embodiments of a DLC film coated plastic container of the present invention.

Fig. 1 is a drawing showing the electrode structure and the like of the present apparatus. As shown in Fig. 1, the present apparatus is equipped with a base (1), a shoulder portion electrode (2) and a body portion electrode (3) mounted to the base (1), and a bottom portion electrode (4) which can be connected to and disconnected from the body portion electrode (3). As shown in Fig. 1, the shoulder portion electrode (2), the body portion electrode (3) and the bottom portion electrode (4) each have inner wall surfaces shaped like the outer shape of a plastic container (5). The shoulder portion electrode (2) is arranged along the shoulder portion of the plastic container (5), the body portion electrode (3) is arranged along the body portion of the plastic container (5), and the bottom portion electrode (4) is arranged along the bottom portion of the plastic container (5). The shoulder portion electrode (2), the body portion electrode (3) and the bottom portion electrode (4) form the outer electrodes of the present apparatus.

When the bottom portion electrode (4) is mounted to the body portion electrode (3), the base (1), the shoulder portion electrode (2), the body portion electrode (3) and the bottom portion electrode (4) form a mutually airtight mounted state. These function as a vacuum chamber equipped with a housing portion (10) for housing the plastic container (5).

As shown in Fig. 1, an insulator (6) is provided between the shoulder portion electrode (2) and the body portion electrode (3), and in this way the shoulder portion electrode (2) and the body portion electrode (3) are electrically insulated from each other. Further, an O-ring (7) is provided between the body portion electrode (3) and the bottom portion electrode (4), and when the bottom portion electrode (4) is mounted, a small gap is formed between the bottom portion electrode (4) and the body portion electrode (3). In this way, while ensuring airtightness between the bottom portion electrode (4) and the body portion electrode (3), electrical insulation is carried out between both electrodes.

An inner electrode (11) is provided in the housing portion (10), and the inner electrode (11) is inserted into the inside of the plastic container (5) housed inside the housing portion (10). The inner electrode (11) is electrically connected to a ground potential.

The inner electrode (11) is formed to have a hollow shape (tube shape), and one blowout hole (not shown in the drawing) which communicates the inside and the outside of the inner electrode (11) is formed in the lower end thereof. Further, instead of providing a blowout hole in the lower end, a plurality of blowout holes (not shown in the drawing) may be formed to pass through the inside and the outside of the inner electrode (11) in the radial direction. A pipeline (12) which communicates with the inside of the inner electrode (11) is connected to the inner electrode (11), and this structure makes it possible for a source gas fed into the inside of the inner electrode (11) via the pipeline (12) to be emitted into the inside of the plastic container (5) via the blowout hole. Further, the pipeline (12) is made of metal and has electrical conductivity. As shown in Fig. 1, the pipeline (12) is used to connect the inner electrode (11) to a ground potential. Further, the inner electrode (11) is supported by the pipeline (12).

As shown in Fig. 1, the output terminal of a high-frequency oscillator (9) is connected to the bottom portion electrode (4) via an interface device (8). The high-frequency oscillator (9) generates a high-frequency voltage between itself and the ground potential, and in this way a high-frequency voltage is applied between the inner electrode (11) and the bottom portion electrode (4). As for the high-frequency electric power source, a power source having a frequency of 13.56MHz is used. The following are all the same.

Next, a description will be given for the process of forming a DLC film on the inner wall surfaces of the plastic container (5) using the present apparatus.

The plastic container (5) is set so that the bottom portion thereof makes contact with the inner surface of the bottom portion electrode (4), and by raising the bottom portion electrode (4), the plastic container (5) is housed in the housing portion (10). At this time, the inner electrode (11) provided in the housing portion (10) is inserted inside the plastic container (5) through the orifice (upper end opening) of the plastic container (5).

When the bottom portion electrode (4) is raised to a prescribed position to hermetically seal the housing portion (10), a state is formed in which the outer periphery of the plastic container (5) makes contact with the inner surfaces of the shoulder portion electrode (2), the body portion electrode (3) and the bottom portion electrode (4). Next, the air inside the housing portion (10) is exhausted through an exhaust outlet (1A) of the base (1) by a vacuum device not shown in the drawing. After the pressure inside the housing portion (10) has been reduced to a required vacuum level, a source gas (e.g., carbon source gases such as aliphatic hydrocarbons, aromatic hydrocarbons and the like) supplied via the pipeline (12) is introduced into the inside of the plastic container (5) from the blowout hole of the inner electrode (11).

After the concentration of the source gas reaches a prescribed value, the high-frequency oscillator (9) is activated to apply a high-frequency voltage between the inner electrode (11) and the outer electrodes, whereby a plasma is generated inside the plastic container (5). In this way, a DLC film is formed on the inner wall surfaces of the plastic container (5).

Namely, the formation of a DLC film on the inner wall surfaces of the plastic container (5) is carried out by a plasma CVD method, wherein electrons accumulate on the inner wall surfaces of the outer electrodes insulated by the plasma generated between the outer electrodes and the inner electrode (11), and a prescribed fall in potential occurs.

In this way, the carbon and the hydrogen of the hydrocarbon that forms the source gas present in the plasma are each ionized to positive. Then, due to the attractive electrostatic force between the ions and the electrons accumulated on the inner wall surfaces, the ions will be attracted by and randomly collide with the inner wall surface of the plastic container (5) running along the inner wall surfaces of the outer electrodes, whereby an extremely dense DLC film is formed on the inner wall surfaces of the plastic container (5) by the bonding between adjacent carbon atoms and the bonding between carbon atoms and hydrogen atoms, and by the breaking of bonds of hydrogen atoms that have bonded once (sputtering effect).

In this regard, the high-frequency electric power applied to the body portion electrode (3) and the shoulder portion electrode (2) becomes smaller than the high-frequency electric power applied to the bottom portion electrode (4). However, because capacity coupling is carried out through the respective gaps between the bottom portion electrode (4) and the body portion electrode (3), and between the body portion electrode (3) and the shoulder portion electrode (2), a certain degree of high-frequency electric power is also applied to the body portion electrode (3) and the shoulder portion electrode (2).

In general, the bottom portion of plastic containers such as bottles and the like have complex shapes, and it is difficult to form a DLC film having a uniform film thickness, composition and density. For this reason, even after the DLC film is formed, the gas barrier properties of the bottom portion of the container are prone to lowering.

In contrast with this, by means of the manufacturing apparatus of the embodiment described above, because it is possible to apply high-frequency electric power larger than that for the body portion and shoulder portion to the bottom portion of the plastic container, it is possible to uniformly form a DLC film having a prescribed film thickness, composition and density on the entire bottle, and it is possible to effectively improve the gas barrier properties for the entire container. In the embodiment described above, the applied electric power was 800 ~ 1400W.

In the present invention, because it is possible to apply high-frequency electric power having a required strength in accordance with each portion of the container, the present invention is not limited to the embodiment described above. For example, a plurality of high-frequency oscillators may be provided to apply high-frequency electric power separately to each of the electrodes of the shoulder portion electrode (2), the body portion electrode (3) and the bottom portion electrode (4), or the output of a single high-frequency oscillator may be connected to each of the electrodes via a plurality of interface devices.

In the embodiment described above, an example was described for the case where the outer electrodes are divided into three portions, but the outer electrodes may be divided into two portions, or the outer electrodes may be divided into four or more portions. Further, in the case of container shapes that make it easy to form a DLC film on the bottom portion, the distribution of applied high-frequency electric power may be adjusted without dividing the outer electrodes.

In the embodiment described above, a description was given for manufacturing based on a high-frequency plasma CVD method. In the embodiment described above, it is possible to form a DLC film having a prescribed composition, density and film thickness as far as the bottom portion even for bottles having complex shapes. By adjusting such formation conditions to the three conditions mentioned in the example embodiments described below, it is possible to achieve the invention of a DLC film coated plastic container having prescribed properties, namely, in addition to the basic properties of (1) good transparency so that the foreign material inspection is not hindered, and (2) no chemical reaction between the container and liquid contents, otherwise the compounding agents, other properties such as (3) aromatic component barrier properties, (4) organic solvent vapor barrier properties, (5) little water vapor permeability, and (6) little oxygen permeability, and the like. However, the method of forming the DLC film is not limited to the method of the embodiment described above. For example, a DLC film may be formed by a manufacturing apparatus based on a microwave plasma CVD method or the like.

In the example embodiments, 500ml PET containers (weight 30g, thickness 0.3mm) were prepared in accordance with the principle of the present invention, and the inner surface area of these containers was 400cm$^2$/container. Accordingly, the gas barrier properties are calculated per one container. In the case where these are converted per unit surface area (m$^2$), conversion may be carried out by considering the inner surface area of the container used for evaluation. Further, because there is almost no gas permeation from the cover, the surface area thereof does not enter into consideration. However, the present invention is not limited by the volume or shape of the containers of the example embodiments.

The PET containers were formed using polyethylene terephthalate resin (Nihon Yunipet (Inc.) RT543 (Intrinsic Viscosity 0.77) ).

METHOD OF ANALYSIS

(1) Measurement of Film Thickness

Thickness was measured by Tenchol Company's alpha-step500 tracer type difference meter.

(2) Surface Area

Measurement was carried out by CAD from the bottle drawing. There was approximately 400cm$^2$ per one

container.

(3) Measurement of Film Weight

The PET bottles were shredded, flakes were placed in a beaker, a reaction with an aqueous solution of 4% NaOH at normal temperature was carried out for 10 hours, and the DLC film was peeled off. This solution was filtered by a milli-pore filter (pore diameter 0.5μ) made of polytetrafluoroethylene, drying was carried out at 105°C, and the weight of the DLC film was calculated from the weights before and after filtering. Because the alkaline solution remains as an impurity, the blank value of the alkaline solution was also calculated, and the weight of the DLC film was corrected.

(4) Measurement of Film Density

The density was calculated from the following equation.

$$\text{Density} = \text{Weight} \div (\text{Surface Area} \times \text{Thickness})$$

(5) Measurement of Hydrogen Atomic Content of Film

The hydrogen atomic % (percentage of the number of hydrogen atoms) of the DLC film was measured [1] using a Shimadzu IBA-9900EREA (elastic recoil detection analysis, elastic recoil particle detection method).
1) A. Kimura, Y. Nakatani, K. Yamada, T. Suzuki, Diamond Relat. Mater. 8 (1999) 37.

(6) Oxygen Permeability

Measurements were made using an Oxtran manufactured by Modern Control Company under the conditions 22°C × 60% RH.

(7) Water Permeability

Measurements were made using an Oxtran manufactured by Modern Control Company under the conditions 40°C × 90% RH.

(8) Ethanol Permeability

250ml of ethanol was placed in 500ml plastic bottles, and then the bottles were sealed. These containers were stored in an air-conditioned chamber at 30°C × 60% RH, and the evaporation losses after one month of storage are shown.

Example Embodiments for Comparing Oxygen Permeability, Water Vapor Permeability, and Ethanol Permeability of DLC Film Coated Containers

Example Embodiment 1

Using the apparatus described above, a DLC film was formed on the inner surfaces of a 500ml PET container with acetylene gas as the source material. Table 1 shows the conditions for forming the DLC film in the present invention. Table 2 shows the various physical properties of the containers depending on the film thickness, density and composition (indicated by the hydrogen content) corresponding to Table 1. The coating conditions were established as mentioned in Example Embodiment 1 of Table 1. The film thickness, density and composition of Example Embodiment 1 and the physical property values of the film thereof are shown in Table 2.

Example Embodiments 2 ～ 19

In the same manner, the film thickness, density and composition of the formed DLC film was changed to establish the example embodiments 2 ～ 19 of Table 1. The measured values of the oxygen permeabilities, the water vapor permeabilities and the ethanol permeabilities at such time are shown in the same manner in Table 2.

Reference Examples 1 ～ 13

DLC films were formed by shifting the conditions for the reference examples from the three conditions of film thickness, density and composition of the DLC films of the example embodiments. The coating conditions were established like the reference examples 1 ～ 13 of Table 1. The various physical properties of the containers at such time are shown in the same manner in Table 2.

Blank Space Below

TABLE 1

| Example Embodiments | Discharge Method | High-Frequency Electric Power w | Film Forming Pressure torr | Gas Flow Rate sccm | Thickness Å | Density g/cm$^3$ | Hydrogen Atomic % |
|---|---|---|---|---|---|---|---|
| Example Embodiment 1 | Bottom | 800 | 0.05 | 31 | 180 | 1.6 | 40 |
| Example Embodiment 2 | Bottom | 800 | 0.05 | 31 | 350 | 1.6 | 40 |
| Example Embodiment 3 | Bottom | 1200 | 0.05 | 31 | 180 | 2.1 | 10 |
| Example Embodiment 4 | Bottom | 1200 | 0.05 | 31 | 350 | 2.1 | 10 |
| Example Embodiment 5 | Bottom | 900 | 0.05 | 31 | 200 | 1.7 | 30 |
| Example Embodiment 6 | Bottom | 900 | 0.05 | 31 | 320 | 1.7 | 30 |
| Example Embodiment 7 | Bottom | 1200 | 0.05 | 31 | 200 | 2.0 | 15 |
| Example Embodiment 8 | Bottom | 1200 | 0.05 | 31 | 320 | 2.0 | 15 |
| Example Embodiment 9 | Bottom | 900 | 0.05 | 31 | 220 | 1.6 | 35 |
| Example Embodiment 10 | Bottom | 900 | 0.05 | 31 | 350 | 1.6 | 35 |
| Example Embodiment 11 | Bottom | 1200 | 0.03 | 31 | 220 | 2.1 | 10 |
| Example Embodiment 12 | Bottom | 1200 | 0.03 | 31 | 350 | 2.1 | 10 |
| Example Embodiment 13 | Bottom | 900 | 0.05 | 31 | 250 | 1.7 | 30 |
| Example Embodiment 14 | Bottom | 1200 | 0.05 | 31 | 250 | 2.0 | 10 |
| Example Embodiment 15 | Bottom | 900 | 0.05 | 31 | 320 | 1.7 | 30 |
| Example Embodiment 16 | Bottom | 1200 | 0.05 | 31 | 320 | 2.0 | 10 |
| Example Embodiment 17 | Bottom | 1000 | 0.07 | 31 | 270 | 1.8 | 26 |
| Example Embodiment 18 | Bottom | 900 | 0.05 | 31 | 300 | 1.6 | 35 |

TABLE 1 (continued)

| Example Embodiments | Discharge Method | High-Frequency Electric Power w | Film Forming Pressure torr | Gas Flow Rate sccm | Thickness Å | Density g/cm$^3$ | Hydrogen Atomic % |
|---|---|---|---|---|---|---|---|
| Example Embodiment 19 | Bottom | 1000 | 0.07 | 31 | 300 | 1.8 | 26 |
| Reference Example 1 | Bottom | 800 | 0.07 | 31 | 150 | 1.3 | 45 |
| Reference Example 2 | Bottom | 1300 | 0.03 | 31 | 450 | 2.2 | 8 |
| Reference Example 3 | Bottom | 1300 | 0.03 | 31 | 400 | 2.2 | 8 |
| Reference Example 4 | Bottom | 1100 | 0.05 | 31 | 100 | 1.9 | 20 |
| Reference Example 5 | Bottom | 1100 | 0.05 | 31 | 500 | 1.9 | 20 |
| Reference Example 6 | Bottom | 800 | 0.07 | 31 | 300 | 1.2 | 48 |
| Reference Example 7 | Bottom | 1400 | 0.03 | 31 | 250 | 2.3 | 6 |
| Reference Example 8 | Bottom | 1300 | 0.03 | 31 | 50 | 2.2 | 8 |
| Reference Example 9 | Bottom | 1300 | 0.03 | 31 | 100 | 2.2 | 8 |
| Reference Example 10 | Bottom | 1300 | 0.03 | 31 | 300 | 2.2 | 8 |
| Reference Example 11 | Bottom | 800 | 0.07 | 31 | 450 | 1,3 | 45 |
| Reference Example 12 (Only PET) | Bottom | — | — | 31 | 0 | — | — |
| Reference Example 13 (Only PP) | Bottom | — | — | 31 | 0 | — | — |

TABLE 2

| Example Embodiments | Thickness | Density | Composition | Permeability and Evaluation | | | | | |
|---|---|---|---|---|---|---|---|---|---|
| | | | Hydrogen Atomic | Oxygen | | Water Vapor | | Ethanol | |
| | Å | g/cm$^3$ | % | ml/container /day | Evaluation | g/container/day | Evaluation | g/container/ month | Evaluation |
| Example Embodiment 1 | 180 | 1.6 | 40 | 0.004 | ○ | 0.006 | ○ | 0.12 | × |
| Example Embodiment 2 | 350 | 1.6 | 40 | 0.004 | ○ | 0.006 | ○ | 0.10 | × |
| Example Embodiment 3 | 180 | 2.1 | 10 | 0.007 | ○ | 0.005 | ○ | 0.11 | × |
| Example Embodiment 4 | 350 | 2.1 | 10 | 0.006 | ○ | 0.006 | ○ | 0.05 | ○ |
| Example Embodiment 5 | 200 | 1.7 | 30 | 0.004 | ◎ | 0.003 | ◎ | 0.10 | × |
| Example Embodiment 6 | 320 | 1.7 | 30 | 0.004 | ◎ | 0.003 | ◎ | 0.02 | ◎ |
| Example Embodiment 7 | 200 | 2.0 | 15 | 0.003 | ◎ | 0.003 | ◎ | 0.09 | × |
| Example Embodiment 8 | 320 | 2.0 | 15 | 0.003 | ◎ | 0.003 | ◎ | 0.03 | ◎ |
| Example Embodiment 9 | 220 | 1.6 | 35 | 0.004 | ◎ | 0.006 | ○ | 0.04 | ○ |
| Example Embodiment 10 | 350 | 1.6 | 35 | 0.004 | ◎ | 0.006 | ○ | 0.05 | ○ |
| Example Embodiment 11 | 220 | 2.1 | 10 | 0.005 | ○ | 0.005 | ○ | 0.04 | ○ |
| Example Embodiment 12 | 350 | 2.1 | 12 | 0.006 | ○ | 0.006 | ○ | 0.03 | ◎ |

TABLE 2 (continued)

| Example Embodiments | Thickness | Density | Composition | Permeability and Evaluation | | | | | |
|---|---|---|---|---|---|---|---|---|---|
| | | | Hydrogen Atomic | Oxygen | | Water Vapor | | Ethanol | |
| | Å | g/cm³ | % | ml/container /day | Evaluation | g/container/day | Evaluation | g/container/ month | Evaluation |
| Example Embodiment 13 | 250 | 1.7 | 30 | 0.004 | ◎ | 0.003 | ◎ | 0.02 | ◎ |
| Example Embodiment 14 | 250 | 2.0 | 10 | 0.003 | ◎ | 0.004 | ○ | 0.04 | ○ |
| Example Embodiment 15 | 320 | 1.7 | 30 | 0.003 | ◎ | 0.002 | ◎ | 0.02 | ◎ |
| Example Embodiment 16 | 320 | 2.0 | 10 | 0.003 | ◎ | 0.004 | ○ | 0.05 | ○ |
| Example Embodiment 17 | 270 | 1.8 | 26 | 0.002 | ◎ | 0.002 | ◎ | 0.01 | ◎ |
| Example Embodiment 18 | 300 | 1.6 | 35 | 0.003 | ◎ | 0.006 | ○ | 0.04 | ○ |
| Example Embodiment 19 | 300 | 1.8 | 26 | 0.002 | ◎ | 0.003 | ◎ | 0.02 | ◎ |
| Reference Example 1 | 150 | 1.3 | 45 | 0.008 | ○ | 0.012 | × | 0.09 | × |
| Reference Example 2 | 450 | 2.2 | 8 | 0.011 | ○ | 0.011 | × | 0.10 | × |
| Reference Example 3 | 400 | 2.2 | 8 | 0.008 | ○ | 0.013 | × | 0.11 | × |
| Reference Example 4 | 100 | 1.9 | 20 | 0.019 | × | 0.014 | × | 0.11 | × |
| Reference Example 5 | 500 | 1.9 | 20 | 0.024 | × | 0.015 | × | 0.12 | × |
| Reference Example 6 | 300 | 1.2 | 48 | 0.028 | × | 0.015 | × | 0.13 | × |
| Reference Example 7 | 250 | 2.3 | 6 | 0.025 | × | 0.018 | × | 0.12 | × |
| Reference Example 8 | 50 | 2.2 | 8 | 0.029 | × | 0.017 | × | 0.16 | × |
| Reference Example 9 | 100 | 2.2 | 8 | 0.023 | × | 0.015 | × | 0.14 | × |

TABLE 2   (continued)

| Example Embodiments | Thickness | Density | Composition | Permeability and Evaluation | | | | | |
|---|---|---|---|---|---|---|---|---|---|
| | | | Hydrogen Atomic | Oxygen | | Water Vapor | | Ethanol | |
| | Å | g/cm$^3$ | % | ml/container /day | Evaluation | g/container/day | Evaluation | g/container/ month | Evaluation |
| Reference Example 10 | 300 | 2.2 | 8 | 0.010 | ○ | 0.012 | × | 0.16 | × |
| Reference Example 11 | 300 | 1.3 | 45 | 0.011 | ○ | 0.011 | × | 0.11 | × |
| Reference Example 12 (Only PET) | 0 | — | — | 0.033 | × | 0.020 | × | 0.19 | × |
| Reference Example 13 (Only PP) | 0 | — | — | 1.05 | × | 0.006 | ○ | 0.68 | × |

From the viewpoint of the ethanol vapor barrier properties, the three conditions of the DLC film are as follows. Namely, the composition condition is that the hydrogen atomic % is 10 ∼ 35 atomic %, and preferably 12 ∼ 30 atomic %. The density condition is 1.6 ∼ 2.2g/cm$^3$, and preferably 1.7 ∼ 2.1 g/cm$^3$. When the film thickness is too thin, the film will be patchy in a state where there are open holes, and the entire surface will not be covered. Further, when the film thickness becomes too thick, compressive stress occurs in the film itself, and this causes the film to crack and peel off. Accordingly, the film thickness condition is 220 ∼ 400Å, and preferably 250 ∼ 370Å.

The DLC film coated plastic container satisfying these three conditions has ethanol vapor barrier properties of less than or equal to 0.06g/container/month.

From the viewpoint of the oxygen barrier properties, the three conditions of the DLC film are as follows. Namely, the composition condition is that the hydrogen atomic % is 8 ∼ 45 atomic %, and preferably 10 ∼ 40 atomic %. The density condition is 1.3 ∼ 2.2g/cm$^3$, and preferably 1.4 ∼ 2.0 g/cm$^3$. The film thickness condition is 150 ∼ 450Å, and preferably 180 ∼ 420Å.

The DLC film coated plastic container satisfying these three conditions has oxygen barrier properties of less than or equal to 0.011ml/container/day.

From the viewpoint of the water vapor barrier properties, the three conditions of the DLC film are as follows. Namely, the composition condition is that the hydrogen atomic % is 10 ∼ 40 atomic %, and preferably 15 ∼ 35 atomic %. The density condition is 1.6 ∼ 2.1g/cm$^3$, and preferably 1.7 ∼ 2.0 g/cm$^3$. The film thickness condition is 180 ∼ 350Å, and preferably 200 ∼ 320Å.

The DLC film coated plastic container satisfying these three conditions has water vapor barrier properties of less than or equal to 0.006g/container/day.

In order to obtain a plastic container for liquid containing volatile organic substances equipped with ethanol vapor barrier properties, oxygen barrier properties and water vapor barrier properties, this is achieved by establishing the three conditions of the DLC film as follows. Namely, the composition condition is that the hydrogen atomic % is 10 ∼ 35 atomic %, and preferably 15 ∼ 30 atomic %. The density condition is 1.6 ∼ 2.1g/cm$^3$, and preferably 1.7 ∼ 2.0 g/cm$^3$. The film thickness condition is 220 ∼ 350Å, and preferably 250 ∼ 320Å.

In the case where the three conditions of the DLC film are established as described above, it is possible to obtain a DLC film coated plastic container having ethanol vapor barrier properties of less than or equal to 0.06g/container/month, oxygen barrier properties of less than or equal to 0.011ml/container/day, and water vapor barrier properties of less than or equal to 0.006g/container/day.

Example Embodiments for Comparing Oxygen Permeability and Water Vapor Permeability of DLC Films Formed on Plastic Films

According to Japanese Laid-Open Patent Publication No. HEI 11-70152, a diamond state DLC film having a hydrogen concentration of 50 atomic % or less and an oxygen concentration of 2 ∼ 20 atomic % is introduced. The oxygen permeability of 25μm biaxial oriented polypropylene is 17.3 ml/m$^2$/day, and the water vapor permeability is 4.5 g/m$^2$/day which is an improvement of barrier properties by a factor of about 2 or 3 times.

The inner surfaces of PET containers were covered by a 12μm thick PET film, and the film obtained by forming a DLC film under the conditions of Example Embodiment 15 of Table 1 formed Example Embodiment 20, and the film obtained by forming a DLC film under the conditions of 17 of Table 1 formed Example Embodiment 21, and the various physical properties of these films are shown in Table 3. As for the 12μm PET films- of the present invention, as shown in Example Embodiments 20, 21 of Table 3, in contrast with the films not formed with a DLC film, the oxygen gas barrier properties were about 100 times better, and the water vapor permeability was about 30 times better.

Blank Space Below

TABLE 3

| Example Embodiment | Film Thickness | Density | Composition | Permeability | |
|---|---|---|---|---|---|
| | | | Hydrogen Atom Content | Oxygen | Water |
| | Å | g/cm$^3$ | Hydrogen Atomic % | ml/m$^2$/Day | g/m$^2$/Day |
| Reference Example 14 (PET12μm) | 0 | — | — | 85 | 45 |

TABLE 3   (continued)

| Example Embodiment | Film Thickness | Density | Composition | Permeability | |
|---|---|---|---|---|---|
| | | | Hydrogen Atom Content | Oxygen | Water |
| | Å | g/cm$^3$ | Hydrogen Atomic % | ml/m$^2$/Day | g/m$^2$/Day |
| Reference Example 15 (PET12μm) | 0 | — | — | 100 | 50 |
| Example Embodiment 20 | 200 | 1.7 | 30 | 1.0 | 2.0 |
| Example Embodiment 21 | 250 | 1.8 | 26 | 0.8 | 1.5 |

Example Embodiments for Comparing the Preservability of Toilet Water of DLC Film Coated Containers

Toilet water has ethanol (10 ~ 12%), moisturizing agents, aromatic materials and purified water as basic components, and special components, for example, astringents, disinfectants, water soluble macromolecules, menthol and the like are added to these. Accordingly, glass containers have been used to prevent ethanol and aromatic materials from evaporating. Plastic containers have not been used in general because they are permeable to organic solvent vapors such as ethanol and aromatic materials and the like.

The evaluation method of the case where the container of the present invention is filled with toilet water is as follows. Toilet water for normal skin which is available on the market was refilled into various 500ml containers, and then the containers were stored for 6 months in an air-conditioned chamber at 40°C × 70RH%. With regard to the functional evaluations, evaluations according to the three rankings of good (○), average (Δ), and poor (×) by a panel of five people were carried out. Table 4 shows the evaluation of the preservability of toilet water for the plastic container for liquid containing volatile organic substances of the present invention. Measurements of the preservability of toilet water were carried out for part of the DLC film coated containers manufactured under the conditions of Table 1. The example embodiment numbers and the reference example numbers shown in Table 4 match each of the numbers shown in Table 2, and are containers manufactured under the same conditions. As is clear from Table 4, compared to the reference examples, the example embodiments 4 and 13 have barrier properties for these organic solvent vapors and aromatic materials.

TABLE 4

| | Functional Evaluation |
|---|---|
| Reference Example 12 (PET only) | × |
| Reference Example 4 | Δ |
| Example Embodiment 4 | ○ |
| Example Embodiment 13 | ○ |
| Glass Container | ○ |
| Good (○), Average (Δ), Poor (×) | |

Example Embodiments for Comparing the Preservability of Seasonings of DLC Film Coated Containers

PET bottles were first used as soy sauce containers because of their good gas barrier properties (oxygen, carbon dioxide gas). Most liquid food (excluding beer and wine) sold on the market is filled in PET containers, but products of edible vinegar filled in PET containers cannot be found. This is because edible vinegar contains 4 ~ 5% acetic acid, and when filled into plastic containers, the odor of the edible vinegar permeates through the container and comes out. It is possible to use nylon (polyamide using metaxylene diamine) which has better gas barrier properties and odor blocking properties than PET resin, but due to high costs, a practical use has not been achieved.

Measurements of the preservability of seasonings were carried out for part of the DLC film coated containers manufactured under the conditions of Table 1. Table 5 shows the evaluation of the preservability of seasonings for the plastic container for liquid containing volatile organic substances of the present invention. The example embodiment numbers and the reference example numbers shown in Table 5 match each of the numbers shown in Table 1, and are containers manufactured under the same conditions.

The evaluation method is as follows. Soy sauce sold on the market and edible vinegar sold on the market were refilled into various 500ml containers and stored at 30°C, 70% RH, and then evaluations of odor were carried out by a panel of five people every day for the first week, and then every week after that. The time when odor was sensed within three days is shown by ▲, the time within 3 ∼ 7 days is shown by ∆, the time within 1 ∼ 2 weeks is shown by ○, and the time greater than 2 weeks is shown by ⊚ . Table 5 shows the evaluation results. PET bottles in which DLC is vapor deposited have superior gas barrier properties and odor barrier properties, and it became clear that such containers can be used satisfactorily.

TABLE 5

| | Standard Odors | |
| --- | --- | --- |
| | Edible Vinegar | Soy Sauce |
| Reference Example 13 (PP only) | ▲ | ▲ |
| Nylon (polyamide using metaxylene diamine) | ○ | ⊚ (One Month) |
| Reference Example 12 (PET only) | ∆ | ⊚ (One Month) |
| Reference Example 4 | ∆ | ⊚ (One Month) |
| Example Embodiment 4 | ○ | ⊚ (One Month) |
| Example Embodiment 13 | ○ | ⊚ (One Month) |
| Symbols of Odor Blocking Properties<br>▲: within 3 days, ∆: Within 3 days∼1 week,<br>○: within 1∼2 weeks, ⊚ : Greater than 2 weeks | | |

Example Embodiments for Comparing the Preservability of Agricultural Chemicals of DLC Film Coated Containers

Example Embodiments (Loss of Organic Solvents)

Organic solvents are used to dissolve agricultural chemicals, but depending on the container, these organic solvents turn to vapor and evaporate to the outside of the container. When this happens, there is the problem of adverse effects on the environment, and this is not preferred because of the occurrence of changes in the components of the agricultural chemicals. In this regard, the loss rates from various containers of normal hexane which is widely used as a solvent of agricultural chemicals were measured, and the results of the present invention were examined.
The containers that were used had a capacity of 300ml, and a weight of 31g. Each container had a thickness of 0.3mm, and an inner surface area of 300cm$^2$. The containers were filled with 250ml of normal hexane, and the openings of the containers were completely sealed. The containers were stored at 30°C, weights were measured regularly at fixed periods, and the loss rates of normal hexane were measured. Each test section was carried out for 5 rows, and the results show the average value of the 5 rows. Odor was judged by smelling odors from the outer surface of the containers two weeks after being filled with chemicals. Evaluations were carried out by a panel of five people according to the three rankings of odoriferous (×), slightly odoriferous (∆), and odorless (○).
The container formed with a DLC film under the conditions of Example Embodiment 4 of Table 1 formed Example Embodiment 22, the container formed with a DLC film under the conditions of Example Embodiment 13 of Table 1 formed Example Embodiment 23, the container formed with a DLC film under the conditions of Reference Example 13 of Table 1 formed Reference Example 16, the container formed with a DLC film under the conditions of Reference Example 12 of Table 1 formed Reference Example 17, and the container formed with a DLC film under the conditions of Reference Example 4 of Table 1 formed Reference Example 18, and the evaluation of the preservability of chemicals (loss rate of normal hexane) for these containers is shown in Table 6.
From the results of example embodiments 22 and 23, it became clear that the present invention makes it possible to prevent the loss of normal hexane.

TABLE 6

| | Odor After 2 Weeks | Loss Rate After 1 Year (%) | Overall Evaluation |
| --- | --- | --- | --- |
| Reference Example 16 (PP only) | × | Not usable as a container | × |
| PAN Only | ○ | 0.3 | ○ |
| Reference Example 17 (PET only) | ∆ | 1.7 | ∆ |
| Reference Example 18 | ∆ | 0.8 | ∆ |

TABLE 6   (continued)

| | Odor After 2 Weeks | Loss Rate After 1 Year (%) | Overall Evaluation |
|---|---|---|---|
| Example Embodiment 22 | ○ | 0.2 | ○ |
| Example Embodiment 23 | ○ | 0.1 | ○ |
| Odor After 2 Weeks: Odoriferous(×),Slightly Odoriferous(Δ), Odorless(○) Stored at 30°C | | | |

Example Embodiments (Stability of Agricultural Chemicals)

Agricultural chemicals are decomposed by the effect of oxygen and water, and it is desired that the used containers form a barrier against oxygen and water. Malathion powder agent (2% content, talc filler) and dithiocarbamate-type zineb water-dispersible agent (72% content) were selected as easily decomposable agricultural chemicals.

The containers that were used had a capacity of 300ml, and a weight of 31g. Each container had a thickness of 0.3mm, and an inner surface area of $300cm^2$. The containers were filled with 50g of each chemical, the openings of the containers were completely sealed, and then after the containers were stored for two months at 40°C and 75% RH, the amounts of remaining agricultural chemicals were analyzed. The malathion agent was analyzed by a gas chromatograph (FID). Further, the zineb water-dispersible agent was analyzed by a method in which decomposition by an acid is carried out, and the carbon disulfide created at such time is reacted with methanol to form xanthate which is then titrated with iodine. Each test section was carried out for 5 rows, and the results show the average value of the 5 rows.

The container formed with a DLC film under the conditions of Example Embodiment 4 of Table 1 formed Example Embodiment 24, the container formed with a DLC film under the conditions of Example Embodiment 13 of Table 1 formed Example Embodiment 25, the container formed with a DLC film under the conditions of Reference Example 12 of Table 1 formed Reference Example 19, and the container formed with a DLC film under the conditions of Reference Example 4 of Table 1 formed Reference Example 20, and the evaluation of the stability of chemicals (decomposition rate) for these containers is shown in Table 7.

Even though there was notable decomposition of the malathion powder agent and the zineb water-dispersible agent, and the addition of a stabilizer was required in the case of storing by plastic containers, from the results of example embodiments 24 and 25, the chemicals remained stable over a long period of time when stored by the containers of the present invention.

TABLE 7

| | Malathion Powder Agent | Zineb Water-Dispersible Agent | Overall Evaluation |
|---|---|---|---|
| PAN Only | 7.0 | 25.0 | ×~Δ |
| Reference Example 19 (PET only) | 19.6 | 21.8 | × |
| Reference Example 20 | 6.8 | 6.2 | Δ |
| Example Embodiment 24 | 1.8 | 1.0 | ○ |
| Example Embodiment 25 | 1.5 | 0.8 | ○ |
| 40°C × RH75 % × 2 Months | | | |

Example Embodiments for Comparing the Permeabilities of Organic Solvents other than Ethanol of DLC Film Coated Containers

Example Embodiments (Permeabilities of Organic Solvent Vapors)

A comparison of the vapor permeabilities was carried out for organic solvents other than ethanol, namely, xylene, methanol, ethyl acetate and toluene. The containers that were used had a capacity of 300ml, and a weight of 31g. Each container had a thickness of 0.3mm, and an inner surface area of $300cm^2$. These containers were filled with 250ml of each organic solvent.

The container formed with a DLC film under the conditions of Example Embodiment 13 of Table 1 formed Example Embodiment 26, the container formed with a DLC film under the conditions of Reference Example 13 of Table 1 formed Reference Example 21, the container formed with a DLC film under the conditions of Reference Example 12 of Table 1 formed Reference Example 22, and the container formed with a DLC film under the conditions of Reference Example 4 of Table 1 formed Reference Example 23, and the permeabilities of organic solvent vapors for these containers are shown in Table 8.

PAN in the table is an acrylonitrile-alkyl acrylate-butadiene copolymer having better gas barrier properties and organic solvent vapor barrier properties than PET, and is used for agricultural chemical containers. The use of only PET was unsatisfactory, and an improvement of barrier properties was required. In comparison with reference examples 21 ~ 23, it became clear that Example Embodiment 26 had high vapor barrier properties for these organic solvents.

Accordingly, it is possible to provide a DLC film coated plastic container having superior flavor barrier properties for aromatic organic substances, and superior gas barrier properties for the above-described volatile organic solvents in the same manner as ethanol.

TABLE 8

| Solvent Name<br>Container Capacity (ml)<br>Inner Surface Area (cm$^2$) | Ethanol<br>300<br>300 | Ethyl Acetate<br>Same as Left<br>Same as Left | Xylene<br>Same as Left<br>Same as Left | Toluene<br>Same as Left<br>Same as Left |
|---|---|---|---|---|
| Reference Example 21 (PP only) | 0.92 | 24.1 | — | 227 |
| PAN | 1.25 | 4.5 | 0.063 | 0.036 |
| Reference Example 22 (PET only) | 0.39 | 2.3 | 0.24 | 0.21 |
| Reference Example 23 | 0.19 | 1.1 | 0.16 | 0.14 |
| Example Embodiment 26 | 0.034 | 0.17 | 0.019 | 0.016 |
| g/container/month | | | | |

## INDUSTRIAL APPLICATION

As described above, with regard to liquid containing volatile organic substances, in particular, agricultural chemicals, cosmetics beginning with perfume, seasonings beginning with vinegar, aromatic materials and the like, the present invention is usable as a container filled with liquid for which it is desired that the leaking of aromatic components to the outside of the container be made extremely small, liquid for which it is desired that changes in concentration of the solvent due to gas permeation of an organic solvent be prevented, and liquid for which it is desired that quality deterioration due to contamination with oxygen and water vapor be prevented.

It is possible to form various other embodiments without departing from the main features and spirit of the present invention. For this reason, the previously described example embodiments are merely simple examples in every respect, and are not to be interpreted as limitations. The scope of the present invention is defined by the scope of the patent claims, and is in no way restricted to the text of the specification. Furthermore, the modifications and changes falling under the uniform scope of the scope of the patent claims are all within the scope of the present invention.

## Claims

1. A plastic container for liquid containing volatile organic substances having a DLC (Diamond Like Carbon) film formed on the inner surfaces thereof, wherein said plastic container has flavor barrier properties for aromatic organic substances, and gas barrier properties for volatile organic solvents by specifying the composition, density and film thickness of said film.

2. The plastic container for liquid containing volatile organic substances having a DLC film formed on the inner surfaces thereof described in Claim 1, wherein the volatile organic solvent is ethanol, methanol, ethyl acetate, normal hexane, xylene or toluene.

3. The plastic container for liquid containing volatile organic substances having a DLC film formed on the inner surfaces thereof described in Claim 1, wherein said volatile organic solvent is ethanol, and the vapor permeability of said ethanol is 0 ~ 0.06g/container/month.

4.  The plastic container for liquid containing volatile organic substances having a DLC film formed on the inner surfaces thereof described in Claim 1, 2 or 3, wherein said water vapor permeability is 0 ~ 0.006g/container/day, and the oxygen permeability is 0 ~ 0.011ml/container/day.

5.  The plastic container for liquid containing volatile organic substances having a DLC film formed on the inner surfaces thereof described in Claim 1, 2, 3 or 4, wherein the liquid containing volatile organic substances is an agricultural chemical, a cosmetic, a seasoning or an aromatic material.

6.  The plastic container for liquid containing volatile organic substances having a DLC film formed on the inner surfaces thereof described in Claim 1, 2, 3, 4 or 5, wherein the plastic container is formed by polyethylene terephthalate resin.

## Fig.1

## INTERNATIONAL SEARCH REPORT

| | International application No. |
|---|---|
| | PCT/JP00/03487 |

| A. CLASSIFICATION OF SUBJECT MATTER |
|---|
| Int.Cl⁷ B65D 1/00, B65D85/00, B65D85/72, B32B 1/02, B32B 9/00, C23C16/27 |
| According to International Patent Classification (IPC) or to both national classification and IPC |

| B. FIELDS SEARCHED |
|---|
| Minimum documentation searched (classification system followed by classification symbols) |
| Int.Cl⁷ B65D 1/00, B65D85/00-85/84, B32B 1/02, B32B 9/00, C23C16/26-16/27 |

| Documentation searched other than minimum documentation to the extent that such documents are included in the fields searched |
|---|
| Jitsuyo Shinan Koho 1922-1996 Toroku Jitsuyo Shinan Koho 1994-2000 |
| Kokai Jitsuyo Shinan Koho 1971-2000 Jitsuyo Shinan Toroku Koho 1996-2000 |

| Electronic data base consulted during the international search (name of data base and, where practicable, search terms used) |
|---|
| |

### C. DOCUMENTS CONSIDERED TO BE RELEVANT

| Category* | Citation of document, with indication, where appropriate, of the relevant passages | Relevant to claim No. |
|---|---|---|
| X | WO, 96/05111, A1 (Kirin Brewery Company, Limited.), 22 February, 1996 (22.02.96) & JP, 08-053116, A & EP, 773166, A | 1-6 |
| Y | JP, 11-026155, A (Mitsui Chemicals, Ltd.), 29 January, 1999 (29.01.99) (Family: none) | 1-6 |
| EX | JP, 11-106920, A (Nissin Electric Co., Ltd.), 20 April, 1999 (20.04.99) (Family: none) | 1-6 |

| ☐ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 August, 2000 (10.08.00) | 22 August, 2000 (22.08.00) |

| Name and mailing address of the ISA/ Japanese Patent Office | Authorized officer |
|---|---|
| Facsimile No. | Telephone No. |

Form PCT/ISA/210 (second sheet) (July 1992)